# EUROPEAN PATENT SPECIFICATION

(11) **EP 0 478 777 B1**
(45) Date of publication and mention of the grant of the patent: **02.11.1994**
(21) Application number: 90908682.9
(22) Date of filing: 04.06.1990
(51) Int. Cl.: C01B 13/11, C23C 16/30, C23C 16/34, C23C 16/40

(54) **COATED DIELECTRIC MATERIAL FOR AN OZONE GENERATOR**
BESCHICHTETES DIELEKTRISCHES MATERIAL FÜR EINEN OZONGENERATOR
MATERIAU DIELECTRIQUE ENDUIT POUR UN GENERATEUR D'OZONE

(30) Priority: 05.06.1989 JP 143610/89
(43) Date of publication of application: 08.04.1992
(73) Proprietor: SUMITOMO PRECISION PRODUCTS COMPANY LIMITED, Amagasaki-shi, Hyogo 660 (JP); OKAZAKI, Sachiko, Tokyo 168 (JP); KOGOMA, Masuhiro, Wakou-shi, Saitama 351-1 (JP)
(72) Inventor: OKAZAKI, Sachiko 20-11, Takaidohigashi 2-chome, Tokyo 168 (JP); KOGOMA, Masuhiro, Saitama 351-1 (JP); HIRAKAWA, Masahiro 14-B-313, Simohozumi 4-chome, Osaka 567 (JP)
(74) Representative: Livsey, Gilbert Charlesworth Norris
(86) International application number: JP9000719
(87) International publication number: WO9015018

(56) References cited:
- EP-A- 0 202 501
- PATENT ABSTRACTS OF JAPAN, vol. 10, no. 31 (C-327)(2088) 6 February 1986, & JP-A-60183046
- JOURNAL OF VACUUM SCIENCE AND TECHNOLOGY: PART A, vol. 5, no. 4, August 1987, New York, US, pages 1675-1679; J. VUILLOD: "Preparation and characterization of plasma enhanced chemical vapor deposited silicon nitride and oxynitride films"

## Description

### Technical Field

The present invention concerns an ozone generator capable of supplying a gaseous ozone at high concentration used for manufacturing semiconductors requiring extremely high cleanness and, more in particular, it relates to a method of forming a protection film comprising SiO₂ and/or SiNₓ on a dielectric material in an ozone generator and it relates to a dielectric material used for an ozone generator for preventing the substances on the surface of the dielectric material from melting during electric discharge and as a result becoming included as an impurity in the gaseous ozone which is generated.

### Background Art

For years it has been noted that the oxidizing power of ozone is useful for sterilization and odour killing use in refrigerators and rooms, and in particular, for application in an oxidizing process such as for an oxidant and a sterilizer in chemical and medicinal plants as well as for semiconductor manufacturing, and in addition for more conventional use for excrement processing facility or sewage facility.

Furthermore, in a production process for semiconductor devices, SiO₂ film is used as an interlayer insulation film for Al wirings, and a CVD (chemical vapour deposition) using TEOS (organic silane) and gaseous ozone of excellent step coverage has been examined for embedding to flatten the groove shape between the wirings.

For general ozone generators, a method of generating a great amount of ozone by silent electric discharge process using air or oxygen as a starting material has been used.

In the silent discharge type ozone generator, a dielectric material is inserted and disposed between electrodes opposed to each other, a high voltage is applied between the electrodes and an oxygen-containing gas is passed through a discharge gap to obtain ozone.

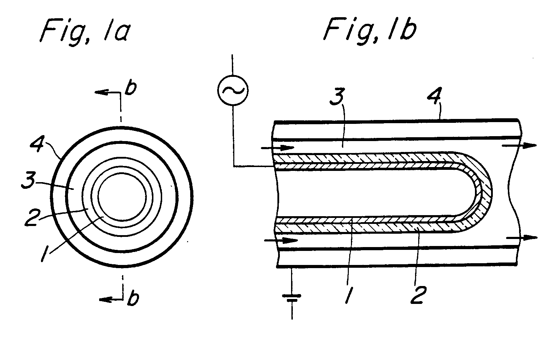

A tubular ozone generator shown in Fig. 1 has a construction in which a glass tube dielectric material (2) is disposed so as to surround a cylindrical tubular high voltage electrode (1) and a tubular water cooling grounding electrode (4) made of stainless steel is disposed by way of a required discharge gap (3), in which air or oxygen is passed through the discharge gap (3) to obtain ozone, the grounding electrode being a double tube through which a coolant such as water is passed through.

In addition, Japanese Patent Publication Sho 51-6110, Japanese Patent Publication Sho 46-42748, etc, propose cylindrical ozone generators of the similar construction.

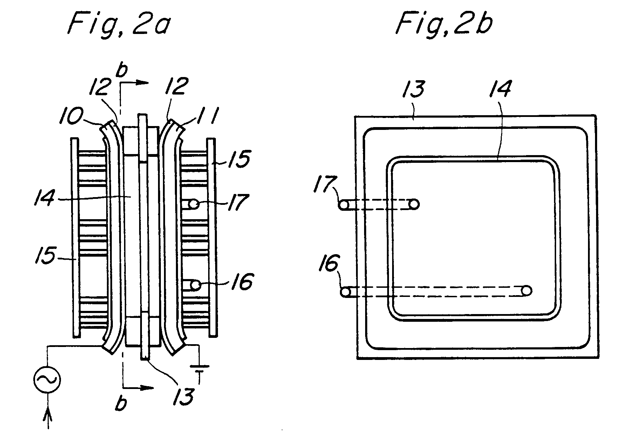

Further, a plane type ozone generator shown in Fig.2 has a structure in which a pair of electrodes consisting of a high voltage electrode (10) and a grounding electrode (11) each laminated with a dielectric material (12) on a flat electrode surface are arranged opposed to each other with an insulating separator (13) and air or oxygen is introduced from one of holes in the direction of an orthogonal line in the thus formed the electric discharge gap (14) and ozone is obtained from other of the holes.

In addition Japanese Patent Publication Sho 45-22930, Japanese Patent Publication Sho 51-6111, Japanese Patent Laid Open Sho. 51-148290, Japanese Utility Model Laid Open Sho 61-125485, etc. propose plate-type ozone generators.

The ozone generators having the respective constitutions as described above involve a problem that since dielectric material is impinged by electrons at high voltage upon discharge in a cell in the device, ingredients of the dielectric material such as enamel or glass may intrude into gaseous ozone or melting of ions or molecules of the electrode may occur to contaminate the generated gaseous ozone.

In view of the above, ceramics with less abrasion, free from leaching of ions or molecules and having high specific dielectric constant have been used for the dielectric material (Japanese Patent Laid Open Sho 55-37483).

Such ceramics are shaped and sintered into various shapes depending on the constitutions of the ozone generators but it can not be said that the mouldability is satisfactory and there is a requirement of securing close bondability with the electrode to prevent oxidative corrosion with respect to the electrode (Japanese Patent Publication Sho. 62-7121).

In particular, such an extremely high cleanness as not containing particles, metal ions, etc. is required for gaseous ozone at high concentration used for the semiconductor steps. However, since the ingredients of the matrix of the dielectric material may possibly be incorporated, even although little, into the gaseous ozone, there is a problem that the utilization to a semiconductor production device is hindered. In view of the foregoing present situation for the ozone generator, it is an object of the present invention to provide an ozone generator in which a protection film of excellent abrasion resistance is deposited extremely easily on to the surface of the dielectric material and in which abrasion of the dielectric material and melting of ions and molecules due to dielectric discharge at an industrially preferable productivity is prevented and it is a further object thereof to provide a dielectric material having a protective film for use in an ozone generator and a method of forming such a protective film.

### Disclosure of the Invention

The present inventors have considered it desirable to use enamel, glass, etc. capable of securing close bond- ability with electrodes of various shapes as the dielectric material in an ozone generator in view of the productivity mouldability thereof and, at first, have noted on disposing a ceramic protection film on the surface of the dielectric material for overcoming the foregoing problem of abrasion and melting of ions or molecules.

For instance, it has been found extremely effective to provide a ceramic protection film on the surface of the dielectric material by means of a sputtering device for preventing melting of matrix ingredients.

However, for disposing a ceramic protection film by using a required ceramic target in a low pressure sputtering device, for example, it is necessary to expose only the surface of the dielectric material by disposing a mask to an electrode and then applying necessary sputtering, after the sputtering the mask is removed and then the ozone generator is assembled. In the case of using enamel, the electrode is contaminated with scales due to sintering so that it gives rise to the problems such as bring about undesired effect to a sputtering device, requiring many steps for disposing the ceramic protection film by using the low pressure sputtering device and so forth.

Then, the present inventors have made various studies with an aim of obtaining a protective film capable of preventing melting of matrix ingredients on the surface of the dielectric material upon electric discharge, as well as a easy method of forming the film and, as a result, we have noted that SiO₂, SiNₓ films formed by normal pressure CVD (chemical vapour deposition) as the protective film are most suitable and, further, have made various studies on the film forming method capable of disposing the protective film extremely easily. As a result, it has been found that SiO₂ film, SiNₓ film can easily be formed on the required surface of dielectric material or, further, electrode surface by processing a starting gas such as, for example, of mono silane: SiH₄, silicon tetrachloride: SiCl₄, nitrogen: N₂ , ammonia: NH₃, or tetraethyl ortho-silicate (TEOS) or a specific reactive gas further incorporated with an inert gas or like under plasma CVD process such as normal pressure CVD or hot CVD. In particular, it has been found that the normal pressure CVD process can be used for depositing a protective film directly to the surface of a dielectric material or electrode in situ in an ozone generator after complete assembly of the ozone generator and have accomplished the present invention.

The present invention comprises a method of coating a dielectric material deposited on or arranged adjacent to an electrode for use in an ozone generator with a protective layer comprising a film of SiO₂ or SiNₓ deposited by vapour phase deposition, characterised in that the protective film is deposited in the presence of an inert gas.

Thus, in general the invention relates to a method of coating a dielectric material deposited on or arranged adjacent to an electrode for use in an ozone generator with a protective layer comprising a film of SiO₂ or SiNₓ deposited by vapour phase deposition, characterised in that the protective film is deposited in the presence of an inert gas. According to a first aspect of the invention, electrodes and dielectric material are arranged in a cell having a discharge space;
a reaction gas is introduced into the discharge space;
and
a high voltage is applied between the electrodes of the cell thereby causing a glow discharge and forming said protective film on the surface of the dielectric material.

In a preferred embodiment of this aspect of the invention, the method comprises using a device having a discharge section comprising one or more electric discharge spaces formed between a high voltage electrode and a grounding electrode having dielectric material deposited thereon or arranged adjacent thereto and having a blowing port downstream of said discharge section, the reaction gas being passed through the electric discharge space.

In a second aspect, the invention is characterised by using a mixer having blowing ports spaced from the dielectric material disposed in a heated cell, a reaction gas comprising an inert gas and an ozone-containing gas being mixed and directed to the dielectric material to form said protective film thereon by vapour phase deposition.

The reaction gas is selected according to the species of film to be deposited. In one embodiment for example, the reaction gas is a silane-containing gas comprising TEOS (tetraethyl orthosilicate Si(OC₂H₅)₄). In preferred embodiments of the invention, the reaction gas is heated.

### BRIEF DESCRIPTION OF THE DRAWINGS

Fig 1a and 1b are a front elevational view and a vertical cross sectional view of a tubular ozone generator;
Fig. 2a and Fig. 2b are a front elevational view and a vertical cross sectional view of a plate-type ozone generator;
Fig. 3 is a schematic explanatory view of a plasma CVD device showing a film-forming method in accordance with the present invention;
Fig. 4 is a schematic explanatory view for another plasma CVD device;
Fig. 5 is a schematic explanatory view or a hot CVD device showing a film forming method according to the present invention; and
Fig. 6 is a schematic explanatory view for another hot CVD device.

### BEST MODE FOR PRACTISING THE INVENTION

The present invention will be explained in more detail with reference to the appended drawings.

### Example 1

A film forming method for a protective film in accordance with the present invention will be explained in a case applied to a typical tubular ozone generator shown in Fig. 1.

The tubular ozone generator has a constitution in which a glass tube dielectric member (2) is arranged so as to surround a tubular high voltage electrode (1) closed at the top and a cylindrical grounding electrode (4) made of stainless steel is disposed by way of a required discharge gap (3), in which air or oxygen is passed through the cylindrical discharge space (3) and a high voltage is applied between the high voltage electrode (1) and the grounding electrode (4) to obtain ozone. Further, the grounding electrode (4) constitutes a double tube in which the coolant such as water is inserted and cooled.

Although not illustrated, the tubular grounding electrode (4) made of stainless steel is closed at both ends thereof forming an introduction port for air or oxygen at one end and a discharge port for generated ozone at other end, and the discharge space (3) as an ozone generating space has a tightly closed structure.

It is so constituted that a reaction gas comprising an inert gas or like and a starting gas in admixture is introduced into the discharge gap (3) kept at an atmospheric pressure and, usually, the gases uniformly passed upon introduction of air or the oxygen at the inside of the discharge gap (3), and the reaction gas is uniformly diffused relative to the dielectric material (2).

After introducing the reactive gas, a predetermined voltage is applied between the high voltage electrode (1) and the grounding electrode (4), by which glow discharge is caused to excite plasmas in the reaction gas and a predetermined protection can be deposited on to the surface of the glass tube dielectric material (2) and the surface of the tubular grounding electrode (4) made of stainless steel.

For preventing the melting of ions and molecules of the glass tube dielectric material (2), a tubular ozone generator using quartz glass for the dielectric material has been used often but, by the use of usual glass instead of quartz glass and forming a protective film of SiO₂, Si₃N₄, etc. by the method according to the present invention, an inexpensive ozone generator can be provided.

### Example 2

A method of forming a protective film in accordance with the present invention will be explained in a case applied to a typical plate-like ozone generator shown in Fig. 2.

The plate-type ozone generator shown in Fig. 2 has such a constitution that a pair electrodes consisting of a high voltage electrode (10) and a grounding electrode (11) each laminated with a dielectric material (12) on the electrode plane are opposed by way of an insulative separator (13), and an introduction tube (16) for introducing air or oxygen and an ozone discharge tube (17) are arranged passing through the electrodes (10),(11) along the direction of a orthogonal line as shown in the drawing in the thus formed discharge gap (14).

When a reaction gas comprising an inert gas or like and a starting gas in admixture is introduced into the discharge gap (14) kept at an atmospheric pressure, the reaction gas is uniformly diffused to the dielectric material (12) due to the effect of arranging the introduction tube (16) and the discharge tube (17) as described above.

After introducing the reaction gas, when a predetermined voltage is applied between the high voltage electrode (10) and the grounding electrode (11) glow discharge occurs to excite plasma in the reaction gas and a predetermined protective film can be formed to the surface of the dielectric material (12).

For instance, in the ozone generator shown in Fig. 2 in which an enamel dielectric material is deposited to the high voltage electrode, SiNₓ film was formed under the following conditions.

### (1) Reactive gas

| Ingredients He-SiCl₄-N₂-H₂ | | |
|---|---|---|
| Flow rate | He | 5000 cm³/min |
| | SiCl₄ | 0.48 cm³/min |
| | N₂ | 20 cm³/min |
| | H₂ | 20 cm³/min |

### (2) Discharge

Atmospheric pressure, normal temperature
RF 13.56 MHz, 200 W

### (3) Enamel dielectric material

Thickness 0.3 mm

### (4) Substrate temperature 400°C

| Ingredient | |
|---|---|
| Silica | 35% |
| Boron Oxide | 18% |
| Alkali metal (Na,K) | 17% |
| Titanium dioxide | 22% |
| Alumina | 1% |
| Fluorine | 5% |
| Phosphorous pentoxide | 2% |

By the film-forming method in accordance with the present invention, an SiNₓ film is obtained at a film- forming rate of 5 µm/hr to the enamel dielectric material. The deposition strength is satisfactory and the film thickness is homogenous.

The ozone generator in accordance with the present invention in which the protective film is deposited on to the dielectric material can prevent abrasion of the dielectric material and melting of ions and molecules due to electric discharge during use.

### Example 3

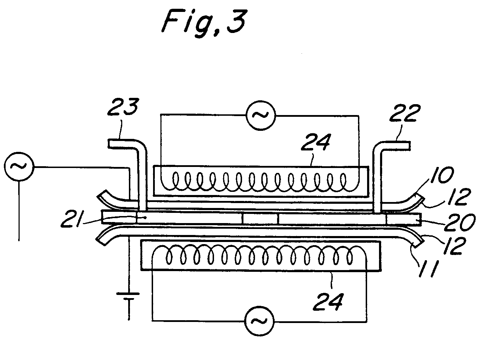

Explanations have been made in Example 2 for the case of directly depositing the protective film on the dielectric material of the plate-type ozone generator in situ after assembly of the generator. In this case, explanation will be made to an example of depositing a protective film on the dielectric material (12) laminated on to the high voltage electrode (1) and the grounding electrode (11) with reference to Fig. 3.

A pair of a high voltage electrode (10) and a grounding a dielectric material electrode (11) each laminated with a dielectric material (12) on the electrode plane are opposed by way of an appropriate insulated separator (20), and an introduction tube (22) for introducing a reaction gas and an exhaust tube (23) are disposed passing through the electrode (10) as shown in the drawing and, further, a heater (24) is disposed for heating the high voltage electrode (10) and the grounding electrode (11) in the thus formed electric discharge gap (21).

After introducing the reaction gas comprising an inert gas or like and a starting gas in admixture into the discharge gap (21) kept at an atmospheric pressure, when a predetermined voltage is applied between the high voltage electrode (10) and the grounding electrode (11), glow discharge is generated which excites plasma in the reactive gas and a predetermined protective film can be disposed on the surface of the dielectric material (12).

For instance, in a case of depositing the enamel dielectric material to the electrode, an SiO₂ film is formed under the following conditions.

The high voltage electrode (10) and the grounding electrode (11) cell is heated to 200 - 300°C by means of the heater (24). TEOS + He are introduced into the discharge gap (21) applied with the predetermined voltage and stable glow discharge with He at atmospheric pressure is caused and TEOS is decomposed with the active species generated by the glow discharge, O₂ contained in He, or O₂ additionally supplied to the introduction gas, to form an SiO₂ film. on the surface of the dielectric material (12).

| | |
|---|---|
| TEOS (Tetraethyl ortho-silicate Si(OC₂H₅)₄) | Flow rate 10.5 cc./min |
| He | Flow rate 5,000 cc/min |
| Discharge gap | 10 mm |
| Power source output | 80 W 1.1 kV 2 kHz |

### Example 4

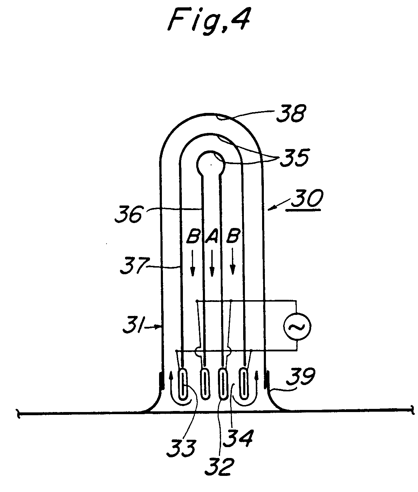

In Example 3, explanations have been made to a case of forming a film by forming a tightly closed discharge gap. In this case, explanation will be made in a case of using a film-forming device constituted as a linear blown type referring to Fig. 4.

In the linear blowing type film-forming device (30), a gas supply tube (35) of a double tube structure is connected to one end, while an exhaust tube (38) is connected to the other end at the closed upper portion of a box-like discharge section (31), and a pair of electrodes (32),(33) each laminated with a dielectric material such as glass on a narrow plate-like electrode surface are disposed by a plurality of pairs by way of an insulative separator not illustrated to the open lower end, to constitute a discharge space (34).

The inside of the discharge section (31) has a double duct structure comprising a duct (36) for gas A and a duct (37) for gas B such that the gas A and the gas B can be supplied individually from the gas supply tube (35) and they are mixed in the discharge space (34) into a required reaction gas.

When the reactive gas is introduced into the discharge space (34) kept at atmospheric pressure and a required voltage is applied between the high voltage electrode (32) and the grounding electrode (33), glow discharge is caused to generate plasma excitation in the reaction gas and a thin film can be formed depending on the kind of the reaction gas to the surface of the material to be deposited with a film opposed to the blowing port of the discharge section (31).

Further, the exhaust gas after the reaction jetted out from the discharge space (34) is turned at a skirt (39) disposed to the open lower end of the discharge section (31), rises up between the inner wall of the discharge section (11) and the duct (37) for the gas B, and is discharged from the exhaust pipe (38) at the upper end of the discharge section (31) and then recovered and regenerated as an inert gas or like. The inert gas or like can be regenerated, if desired.

For instance, an SiO₂ film is formed under the following conditions in an example of a material to be formed with a film prepared by depositing an enamel dielectric material on the electrode as in Example 3.

That is, the electrode cell is heated by a heater to 200 to 300°C and TEOS + He are introduced into the gas A and O₂ is introduced into the gas B in the discharge electric discharge section (31) applied with a predetermined voltage, to decompose TEOS and deposit a film of SiO₂ to the surface of the dielectric material of the electrode cell.

In the Examples 1, 2, 3 and 4 described above, H₂, Ne, Ar, N₂ etc. may be used alone or as a mixture properly for the inert gas, and it is preferred to use a rare gas mainly composed of He as a dilution gas for maintaining a stable glow discharge near atmospheric pressure.

Further, the starting gas to be introduced in admixture with the inert gas or like is required to have a function that the protective film formed can prevent the abrasion of the dielectric material and the electrode and melting of ions and molecules due to the electric discharge and to have a nature as a dielectric material. For instance, in a case where the protective film is SiO₂, there can be used TEOS, mono silane (SiH₄) (thermal decomposition), disilane (SiH₆), silicon tetrachloride (SiCl₄) (hydrogen reduction) or oxygen (O₂) in a case where the protective film is SiO₂ and mono silane (SiH₄), disilane (Si₂H₆) silicon tetrachloride (SiCl₄), nitrogen (N₂), or ammonia (NH₃) in a case where the protective film is SiN₂.

The mixing ratio between the inert gas or like and the starting gas is optional within the range capable of maintaining stable glow discharge near the atmospheric pressure, but it is preferred that the inert gas or like concentration more than about 65%, in particular, more than about 90%. As the reaction gas introduced, a plurality species of gases may also be used.

Generally speaking, glow discharge does not take place easily under an atmospheric pressure, but stable glow discharge is possible at or near atmospheric pressure since a glass dielectric material is deposited, for example, so as to surround the high voltage electrode and the inert gas is introduced.

Referring to the plasma excitation in the reaction gases, the glow discharge excites the inert gas as the dilution gas to form plasma at high energy exited state. Further, the reaction gas causes chemical reaction by being dissociated and ionized in the plasmas to deposit reaction products on the surface of solid.

The plasmas are formed by applying a high voltage and an AC voltage is applied is used for exciting an alternating voltage on the electric material, for which a high frequency voltage from several tens Hz to several MHz may be used, which can be properly selected depending on the kind of the protective film, the property of the surface to be treated and the time for the surface treatment and also may be selected properly depending on the constitution of the ozone generator, the discharge space, the inert gas or like and the starting gas, which is preferably within a range from 1 to 10 kV, from 500 to 13.56 MHz and from 10 W to several KW.

For obtaining a stable glow discharge, an appropriate means can be adopted such as gradual increase of the discharge current or use of pulsative power source.

Further, multi-layered films can be formed by conducting the film formation in accordance with the present invention for several times while replacing the reaction gas.

### Example 5

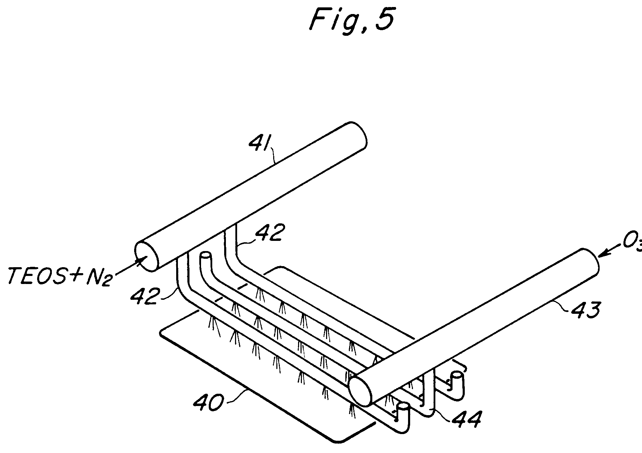

Fig. 5 shows an example of a device forming an SiO₂ film on the surface of a dielectric material of an electrode having a large surface area, in which TEOS is decomposed with O₃ gas at the surface of the dielectric material at or near the atmospheric pressure to form an SiO₂ film. A plurality of branched pipes (42) are disposed to a supply pipe (41) for TEOS + N₂ gas each on which are disposed gas apertures so that reaction gas can be sprayed to the surface of a material (40) to be formed with film.

Further, a plurality of branched pipes (44) each disposed with gas apertures so that O₃ gas can be sprayed to the surface of the material (40) to be formed with film are also disposed to an O₃ supply tube (43). The film-formed material (40) opposed to the gas apertures for each of the branched pipes (42), (44) with a gap of 8 to 15 mm, preferably, 10 to 12 mm is heated by means of a heater not illustrated to 150 to 350°C, preferably, 200 to 300°C, by which TEOS is decomposed by O₃ gas at the surface of the dielectric material of the film-formed material (40) and the SiO₂ film can be formed.

### Example 6

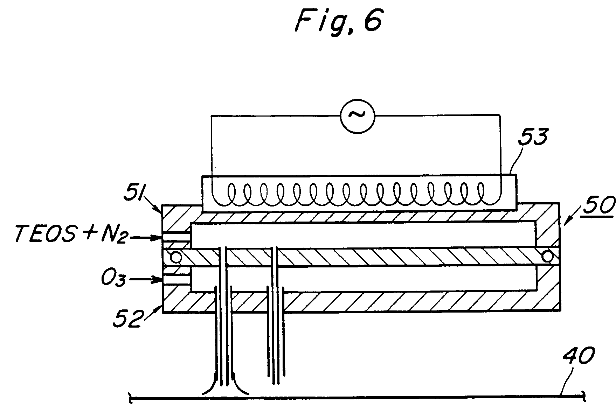

Fig. 6 also shows an example of decomposing TEOS with O₃ gas at the surface of a dielectric material at or near the atmospheric pressure to form an SiO₂ film like that in Example 5.

A gas mixer (50) for bubbling TEOS with N₂ and mixing them with O₃ gas at the surface of a material (40) to be formed with film may comprise various structures such as a double-walled structure as described above. In this embodiment, a plate-like TEOS + N₂ gas supply section (51) and an O₃ gas supply section (52) are disposed in lamination and double-walled pipe passing through both of the sections are appropriately disposed, in which TEOS is bubbled with N₂ and they are mixed with O₃ at the surface of the film-formed material (40). A heater (59) for elevating temperature up to about 100°C is disposed to TEOS + N₂ gas supply section (51)

The film-formed material (40) is heated to 200 - 300°C by a heater not illustrated.

By properly selecting the distance between the gas blowing port of the mixer (50) and the surface of the film-formed material (40) depending on the flow rate and the flow velocity, etc. of the gas so that the film thickness is made uniform, by which TEOS is decomposed with O₃ gas to form an SiO₂ film on the surface of the dielectric material of the film-formed material (40).

### Industrial applicability

In accordance with the present invention, it is possible to easily and inexpensively deposit a protective film made of SiO₂ or SiNₓ on the dielectric material of an ozone generator, and this can prevent the surface substances of the dielectric material from melting in the electric discharge and intrude as a impurity in the ozone gas.

The ozone generator according to the present invention can supply an ozone gas at high concentration used for the manufacture of semiconductors requiring extremely high cleanness.

## Claims

1. A method of coating a dielectric material deposited on or arranged adjacent to an electrode for use in an ozone generator with a protective layer comprising a film of SiO₂ or SiNₓ deposited by vapour phase deposition, wherein electrodes and dielectric material are arranged in a cell having a discharge space;
a reaction gas is introduced into the discharge space;
and
a high voltage is applied between the electrodes of the cell thereby causing a glow discharge and forming said protective film on the surface of the dielectric material, characterised in that the protective film is deposited in the presence of an inert gas.

2. A method according to claim 1, wherein the vapour phase deposition is carried out in situ in an assembled ozone generator.

3. A method according to claim 1, which comprises using a device having a discharge section comprising one or more electric discharge spaces formed between a high voltage electrode and a grounding electrode having dielectric material deposited thereon or arranged adjacent thereto and having a blowing port downstream of said discharge section, the reaction gas being passed through the electric discharge space.

4. A method according to any one of claims 1 to 3, wherein the reaction gas is a silane containing gas comprising TEOS (tetraethylorthosilicate Si(OC₂H₅)₄).

5. A method according to any one of claims 1 to 5, wherein the reaction gas is heated.

6. A method of coating a dielectric material deposited on or arranged adjacent to an electrode for use in an ozone generator with a protective layer comprising a film of SiO₂ or SiNₓ deposited by vapour phase deposition, characterised by using a mixer having blowing ports spaced from the dielectric material disposed in a heated cell, a reaction gas comprising an inert gas and an ozone-containing gas being mixed and directed to the dielectric material to form said protective film thereon by vapour phase deposition.

7. A method according to Claim 6, wherein the reaction gas is a silane-containing gas comprising TEOS (tetraethyl orthosilicate Si(OC₂H₅)₄).

## Patentansprüche

1. Ein Verfahren zum Beschichten eines auf oder in der Nähe einer Elektrode zur Anwendung in einem Ozongenerator abgelagerten dielektrischen Materials mit einer einen Film aus SiO₂ oder SiNₓ aufweisenden mittels Dampfphasenablagerung abgelagerten Schutzschicht, bei dem Elektroden und dielektrisches Material in einer einen Entladungsraum aufweisenden Zelle angeordnet sind,
ein Reaktionsgas in den Entladungsraum eingeleitet wird,
und
eine Hochspannnung zwischen die Elektroden der Zelle angelegt wird, wodurch eine Glimmentladung bewirkt und der besagte Schutzfilm auf der Oberfläche des dielektrischen Materials gebildet wird, dadurch gekennzeichnet, daß der Schutzfilm in Gegenwart eines inerten Gases abgelagert wird.

2. Ein Verfahren nach Anspruch 1, bei dem die Dampfphasenablagerung an Ort und Stelle in einem zusammengebauten Ozongenerator durchgeführt wird.

3. Ein Verfahren nach Anspruch 1, welches die Verwendung einer Vorrichtung umfaßt, die einen Entladungsabschnitt aufweist mit einem oder mehreren elektrischen Entladungsräumen, die zwischen einer Hochspannungselektrode und einer geerdeten Elektrode gebildet sind, auf denen oder in deren Nähe dielektrisches Material abgelagert ist, und die stromabwärts zum besagten Entladungsabschnitt eine Blasöffnung aufweist und bei dem das Reaktionsgas durch den elektrischen Entladungsraum geleitet wird.

4. Ein Verfahren nach einem der Ansprüche 1 bis 3, bei welchem das Reaktionsgas ein Silan enthaltendes Gas einschließlich TEOS (Tetraäthylorthosilikat Si(OC₂H₅)₄) ist.

5. Ein Verfahren nach einen der Ansprüche 1 bis 5, bei welchem das Reaktionsgas erwärmt wird.

6. Ein Verfahren zum Beschichten eines auf oder in der Nähe einer Elektrode zur Anwendung in einem Ozongenerator abgelagerten dielektrischen Materials mit einer einen Film aus SiO₂ oder SiNₓ aufweisenden mittels Dampfphasenablagerung abgelagerten Schutzschicht gekennzeichnet durch die Verwendung eines Mischers mit im Abstand von dem in einer beheizten Zelle angeordneten dielektrischen Material liegenden Blasöffnungen, eines Reaktionsgases, das ein inertes Gas und ein ozonhaltiges Gas enthält, die gemischt und auf das dielektrische Material gerichtet werden, zur Bildung des besagten Schutzfilms darauf mittels Dampfphasenablagerung.

7. Ein Verfahren nach Anspruch 6, bei welchem das Reaktionsgas ein Silan enthaltendes Gas einschließlich TEOS (Tetraäthylorthosilikat Si(OC₂H₅)₄) ist.

## Revendications

1. Procédé de revêtement d'un matériau diélectrique déposé sur ou adjacent à une électrode pour utilisation dans un générateur d'ozone d'une couche protectrice comportant une pellicule de SiO₂ ou SiNx déposée par dépôt en phase vapeur, dans laquelle les électrodes et le matériau diélectrique sont disposés dans une cellule ayant un intervalle de décharge;
- un gaz de réaction est introduit dans l'intervalle de décharge; et
- une haute tension est appliquée entre les électrodes de la cellule provoquant ainsi une décharge incandescente et formant la pellicule protectrice à la surface du matériau diélectrique, caractérisé en ce que la pellicule protectrice est déposée en présence d'un gaz inerte.

2. Procédé suivant à la revendication 1, dans lequel le dépôt en phase vapeur est réalisé in situ dans un générateur d'ozone assemblé.

3. Procédé suivant à la revendication 1, qui comporte l'utilisation d'un dispositif ayant une zone de décharge électrique comportant un ou plusieurs intervalles se décharge électrique formés entre une électrode haute tension et une électrode de terre ayant un matériau diélectrique déposé sur elle ou disposé adjacent à elle et possédant un orifice de soufflage à l'aval de ladite zone de décharge, le gaz de réaction passant dans l'intervalle de décharge électrique.

4. Procédé suivant l'une quelconque des revendications 1 à 3, dans lequel le gaz de réaction est un gaz contenant un silane comprenant du TEOS (orthosilicate de tétraéthyle Si(OC₂H₅)₄).

5. Procédé suivant l'une quelconque des revendications 1 à 4, dans lequel le gaz de réaction est chauffé.

6. Procédé de revêtement d'un matériau diélectrique déposé sur ou adjacent à une électrode pour utilisation dans un générateur d'ozone d'une couche de protection comportant une pellicule de SiO₂ ou Si Nx déposé pour le procédé de dépôt en phase vapeur, caractérisé en ce que l'on utilise un mélangeur possédant des orifices de soufflage à distance du matériau diélectrique disposé dans une cellule chauffée, un gaz de réaction comprenant un gaz inerte et un gaz contenant de l'ozone étant mélangés et dirigés sur le matériau diélectrique pour y former à la surface la pellicule protectrice par dépôt en phase vapeur.

7. Procédé suivant à la revendication 6, dans laquelle le gaz de réaction est un gaz contenant un silane comprenant du TEOS (orthosilicate de tétraéthyle Si(OC₂H₅)₄).
